# EUROPEAN PATENT APPLICATION

(11) **EP 4 657 502 A1**
(43) Date of publication of application: **03.12.2025**
(21) Application number: 24779814.3
(22) Date of filing: 21.03.2024
(51) Int. Cl.: H01L 21/301, B23K 26/364

(54) **LASER PROCESSING METHOD AND DEVICE**

(30) Priority: 31.03.2023 JP 2023058061
(71) Applicant: Tokyo Seimitsu Co., Ltd., Hachioji-shi, Tokyo 192-8515 (JP)
(72) Inventor: HAYASHI Hirokazu, Hachioji-shi, Tokyo 192-8515 (JP)
(74) Representative: Gill Jennings & Every LLP
(86) International application number: PCT/JP2024/010944
(87) International publication number: WO 2024/203691

(57) **Abstract**

Provided is a laser machining method of machining a second groove in a workpiece using a laser machining unit including a first machining unit capable of machining two first grooves in the workpiece by radiating a pair of laser beams to the workpiece to which a machining feed operation is relatively applied and two second machining units arranged on both sides of the first machining unit in a machining feed direction, the two second machining units being capable of machining an area between the two first grooves by radiating a laser beam between the two first grooves to be machined by the first machining unit. The second groove formed by hollowing out an area between the two first grooves is machined by applying a plurality of machining feed operations. In a first machining feed operation, the area between the two first grooves with the second machining unit positioned on a downstream side of the first machining unit is machined in a machining progress direction while the two first grooves are machined in the workpiece by the first machining unit. The area between the two first grooves is machined using the two second machining units in second and subsequent machining feed operations.

## Description

### TECHNICAL FIELD

The present invention relates to a laser machining method and device, and more particularly to a laser machining method and device for machining a groove in a workpiece. Priority is claimed on Japanese Patent Application No. 2023-058061, filed March 31, 2023, the content of which is incorporated herein by reference.

### BACKGROUND ART

When chips are created from semiconductor wafers with a low-k (low dielectric constant) film as an interlayer insulating film using a normal blade dicer, there is a problem because delamination occurs.

Patent Document 1 proposes a method of suppressing delamination by machining two grooves along streets with laser beams and cutting an area between the two grooves with a blade as a method of machining a wafer having a low-k film.

Moreover, Patent Document 2 proposes a method of machining two grooves along streets with laser beams and cutting an area between the two grooves with a laser beam.

Moreover, Patent Document 3 proposes a process for machining two grooves along a street with laser beams, hollowing out an area between the two grooves with a laser beam, and removing a laminate with a low-k value from the street.

### Citation List

### Patent Document

Patent Document 1: Japanese Unexamined Patent Application, First Publication No. 2005-142398
Patent Document 2: Japanese Unexamined Patent Application, First Publication No. 2009-182019
Patent Document 3: Japanese Unexamined Patent Application, First Publication No. 2021-192922

### SUMMARY OF INVENTION

### Technical Problem

Incidentally, there is a need to perform a process for machining each street in a single machining feed operation, i.e., a single path, so that a process for machining a wafer is efficiently performed.

However, in laser machining, according to a machining target, there may be a trade-off between machining quality and an amount of removal per path.

The present invention has been made in consideration of the above circumstances and an objective of the present invention is to provide a laser machining method and device for enabling a workpiece to be efficiently machined while maintaining machining quality.

### Solution to Problem

According to a first aspect for solving the above-described problems, there is provided a laser machining method of machining a second groove in a workpiece using a laser machining unit including a first machining unit capable of machining two first grooves in the workpiece by radiating a pair of laser beams to the workpiece to which a machining feed operation is relatively applied and two second machining units arranged on both sides of the first machining unit in a machining feed direction, the two second machining units being capable of machining an area between the two first grooves by radiating a laser beam between the two first grooves to be machined by the first machining unit, the laser machining method including: machining the second groove formed by hollowing out an area between the two first grooves by applying a plurality of machining feed operations; machining the area between the two first grooves with the second machining unit positioned on a downstream side of the first machining unit in a machining progress direction while machining the two first grooves in the workpiece with the first machining unit in a first machining feed operation; and machining the area between the two first grooves using the two second machining units in second and subsequent machining feed operations.

According to a second aspect, in the laser machining method according to the first aspect, an intensity of a laser beam emitted from the second machining unit changes at least between the first machining feed operation and the second and subsequent machining feed operations.

According to a third aspect, there is provided a laser machining method of machining a second groove in a workpiece using a laser machining unit including a first machining unit capable of machining two first grooves in the workpiece by radiating a pair of laser beams to the workpiece to which a machining feed operation is relatively applied and two second machining units arranged on both sides of the first machining unit in a machining feed direction, the two second machining units being capable of machining an area between the two first grooves by radiating a laser beam between the two first grooves to be machined by the first machining unit, the laser machining method including: machining the second groove formed by hollowing out the area between the two first grooves in the workpiece by machining the area between the two first grooves machined by the first machining unit by radiating a laser beam with a first intensity to the workpiece from the second machining unit positioned on a downstream side of the first machining unit in a machining progress direction while machining the two first grooves in the workpiece with the first machining unit, and by machining in advance the area between the two first grooves to be machined by the first machining unit by radiating a laser beam with a second intensity lower than the first intensity from the second machining unit positioned on an upstream side of the first machining unit in a machining progress direction.

According to a fourth aspect, the laser machining method according to the third aspect includes: machining the second groove by applying a plurality of machining feed operations; machining the area between the two first grooves machined by the first machining unit by radiating the laser beam with the first intensity to the workpiece from the second machining unit positioned on the downstream side of the first machining unit in the machining progress direction while machining the two first grooves in the workpiece with the first machining unit, and machining in advance the area between the two first grooves to be machined by the first machining unit by radiating the laser beam with the second intensity lower than the first intensity from the second machining unit positioned on the upstream side of the first machining unit in the machining progress direction, in a first machining feed operation; and machining the area between the two first grooves by radiating laser beams with the first intensity from the two second machining units in second and subsequent machining feed operations.

According to a fifth aspect, in the laser machining method according to the third or fourth aspect, the workpiece is a semiconductor wafer using a low-k film in an inter-layer insulating film, and the second intensity is set to an intensity lower than an intensity in which delamination occurs.

According to a sixth aspect, there is provided a laser machining device including: a laser machining unit including a first machining unit capable of machining two first grooves in the workpiece by radiating a pair of laser beams to the workpiece to which a machining feed operation is relatively applied; and two second machining units arranged on both sides of the first machining unit in a machining feed direction, the two second machining units being capable of machining an area between the two first grooves by radiating a laser beam between the two first grooves to be machined by the first machining unit; a table configured to hold the workpiece; a machining feed unit configured to apply the machining feed operation by relatively moving the laser machining unit and the table; and a control unit configured to control the machining by controlling the laser machining unit and the machining feed unit, in which the control unit controls the laser machining unit and the machining feed unit so that a second groove formed by hollowing out the area between the first grooves is machined in the workpiece according to a plurality of machining feed operations, in which the control unit controls the laser machining unit and the machining feed unit so that the area between the two first grooves is machined by the second machining unit positioned on a downstream side of the first machining unit in a machining progress direction while the first machining unit machines the two first grooves in the workpiece in a first machining feed operation, and in which the control unit controls the laser machining unit and the machining feed unit so that the area between the two first grooves is machined using the two second machining units in second and subsequent machining feed operations.

According to a seventh aspect, there is provided a laser machining device including: a laser machining unit including a first machining unit capable of machining two first grooves by radiating a pair of laser beams to the workpiece to which a machining feed operation is relatively applied; and two second machining units arranged on both sides of the first machining unit in a machining feed direction, the two second machining units being capable of machining an area between the two first grooves by radiating a laser beam between the two first grooves to be machined by the first machining unit; a table configured to hold the workpiece; a machining feed unit configured to apply the machining feed operation by relatively moving the laser machining unit and the table; and a control unit configured to control the machining by controlling the laser machining unit and the machining feed unit, in which the control unit controls the laser machining unit and the machining feed unit so that a second groove formed by hollowing out the area between the first grooves is machined in the workpiece according to at least one machining feed operation, and in which the control unit controls the laser machining unit and the machining feed unit so that the area between the two first grooves machined by the first machining unit is machined by radiating the laser beam with the first intensity to the workpiece from the second machining unit positioned on a downstream side of the first machining unit in a machining progress direction while the two first grooves are machined in the workpiece by the first machining unit and so that the area between the two first grooves to be machined by the first machining unit is machined in advance by radiating the laser beam with a second intensity lower than the first intensity from the second machining unit positioned on an upstream side of the first machining unit in the machining progress direction.

According to an eighth aspect, in the laser machining device according to the seventh aspect, the control unit controls the laser machining unit and the machining feed unit so that the second groove is machined in the workpiece by a plurality of machining feed operations, the control unit controls the laser machining unit and the machining feed unit so that the area between the two first grooves machined by the first machining unit is machined by radiating the laser beam with the first intensity to the workpiece from the second machining unit positioned on the downstream side of the first machining unit in the machining progress direction while the two first grooves are machined in the workpiece by the first machining unit and the area between the two first grooves to be machined by the first machining unit is machined in advance by radiating the laser beam with the second intensity lower than the first intensity from the second machining unit positioned on the upstream side of the first machining unit in the machining progress direction, in a first machining feed operation, and the control unit controls the laser machining unit and the machining feed unit so that the area between the two first grooves is machined by radiating laser beams with the first intensity from the two second machining units in second and subsequent machining feed operations.

According to a ninth aspect, in the laser machining device according to the seventh or eighth aspect, the workpiece is a semiconductor wafer using a low-k film in an inter-layer insulating film, and the second intensity is set to an intensity lower than an intensity in which delamination occurs.

### Advantageous Effects of Invention

According to the present invention, it is possible to efficiently machine a workpiece while maintaining machining quality.

### BRIEF DESCRIPTION OF DRAWINGS

[FIG. 1] A plan view showing an example of a machining target.
[FIG. 2] A diagram showing an overview of a groove machining process.
[FIG. 3] A schematic diagram showing an embodiment of a laser machining device.
[FIG. 4] A schematic diagram showing an example of a hardware configuration of a control device.
[FIG. 5] A schematic diagram showing an embodiment of a laser machining head.
[FIG. 6] A conceptual diagram of irradiation of a first laser beam from a first condenser lens.
[FIG. 7] A schematic diagram showing an example of a configuration of an optical path switching unit.
[FIG. 8] A conceptual diagram of irradiation of a second laser beam from a second condenser lens.
[FIG. 9] A conceptual diagram of machining of a wiring layer removal groove.
[FIG. 10] A flowchart showing a flow of a machining process of the laser machining device.
[FIG. 11] A conceptual diagram of machining of a wiring layer removal groove.
[FIG. 12] A flowchart showing a flow of a machining process of the laser machining device.
[FIG. 13] A diagram showing another example of a means for adjusting an amount of splitting of a second laser beam.
[FIG. 14] A diagram showing another example of a method of adjusting an intensity of the second laser beam.

### DESCRIPTION OF EMBODIMENTS

Hereinafter, preferred embodiments of the present invention will be described with reference to the accompanying drawings.

### [First embodiment]

Here, an example in which the present invention is applied to a device for removing a wiring layer (a laminate) including a low-k film from streets before dicing a semiconductor wafer that uses a low-k film as an interlayer insulating film will be described. The wafer is an example of a workpiece.

The low-k film serving as the interlayer insulating film is made of a low-k material (a low dielectric constant material). Examples of the low-k material include inorganic materials such as SiO₂, SiOC, and SiLK, organic materials, which are polymers such as polyimide, parylene, and polytetrafluoroethylene, a porous silica material such as methyl-containing polysiloxane, and the like.

### [Overview of machining]

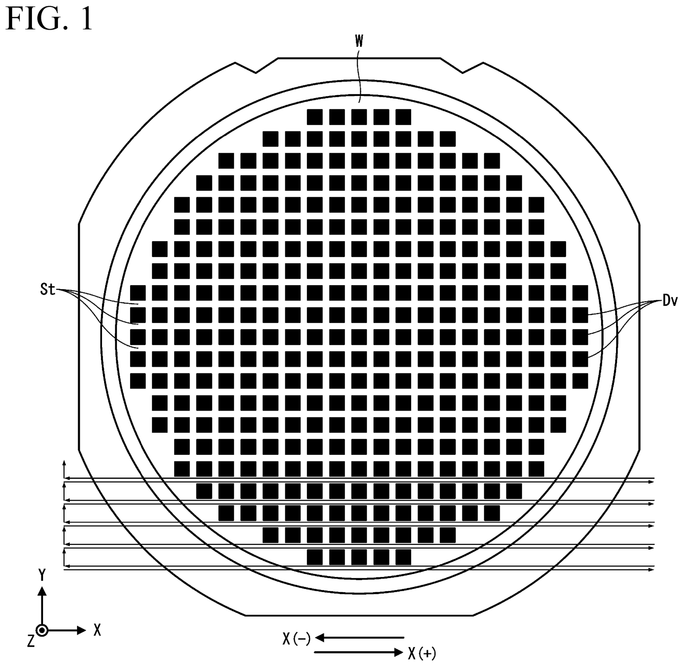

FIG. 1 is a plan view showing an example of a machining target.

As shown in FIG. 1, a semiconductor wafer W that is the machining target has devices Dv formed in lattice-like regions partitioned by a plurality of streets St, which are scheduled division lines. In a wafer W using a low-k film as an interlayer insulating film, the low-k film is positioned across the streets St between adjacent devices Dv. A predetermined groove is ablated for each street St with a laser beam and the wiring layer including the low-k film is removed from the streets St.

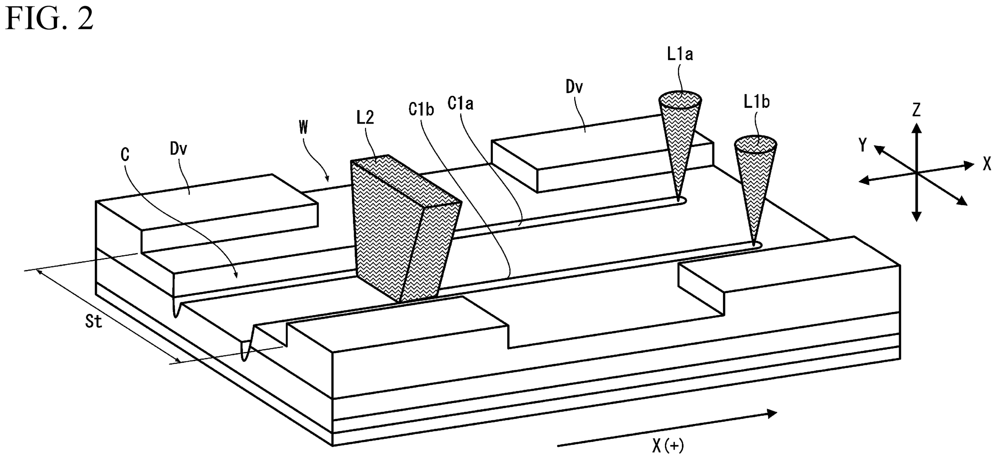

FIG. 2 is a diagram showing an overview of the groove machining.

As shown in FIG. 2, a predetermined groove C is machined along the street St and the wiring layer including the low-k film is removed from the street St. At this time, the groove C is machined in a state in which the process is divided into a machining process of cutting edges on both sides of the groove C and a machining process for cutting the inside the groove C, i.e., a hollowing process. Hereinafter, the machining process for cutting the edges on both sides of the groove C is referred to as an "edge cutting process" and the machining process for cutting the inside of the groove C is referred to as a "hollowing process."

The edge cutting process is performed by radiating a pair of laser beams L1a and L1b along the street St and machining two grooves C1a and C1b parallel to each other along the street St. The two grooves C1a and C1b are machined in the Y direction at an interval corresponding to the width of the groove C to be machined. The two grooves C1a and C1b are also machined in the Z direction at a depth corresponding to the depth of the groove C to be machined.

The hollowing process is performed by radiating a laser beam L2 having a predetermined width between the two grooves C1a and C1b formed by the edge cutting process. This laser beam L2 is configured as a laser beam capable of machining a groove having a width corresponding to spacing between the two grooves C1a and C1b.

By combining the edge cutting process and the hollowing process, the groove C having a predetermined width and depth is finally formed along the street St.

If the groove C is machined using a laser beam of an output that can remove the low-k film all at once, there is a risk that delamination will occur. However, it is possible to suppress the occurrence of delamination by performing a machining process divided into the edge cutting process and the hollowing process to machine the groove C as described above.

In the present embodiment, so-called multi-path machining for machining the required groove C along the street St by applying a plurality of machining feed operations (feed operations in a groove machining direction) is performed. This will be described in detail below.

Hereinafter, the pair of laser beams L1a and L1b used in the edge cutting process will be referred to as "first laser beams L1a and L1b," and a laser beam L2 used in the hollowing process will be referred to as a "second laser beam L2," to distinguish between the two. Moreover, the two grooves C1a and C1b machined in the edge cutting process will be referred to as "edge cutting grooves C1a and C1b," and the groove C machined by the edge cutting process and the hollowing process will be referred to as a "wiring layer removal groove C," to distinguish between the two. The edge cutting grooves C1a and C1b are examples of a first groove. Moreover, the wiring layer removal groove C is an example of a second groove.

### [Laser machining device]

### [Device configuration]

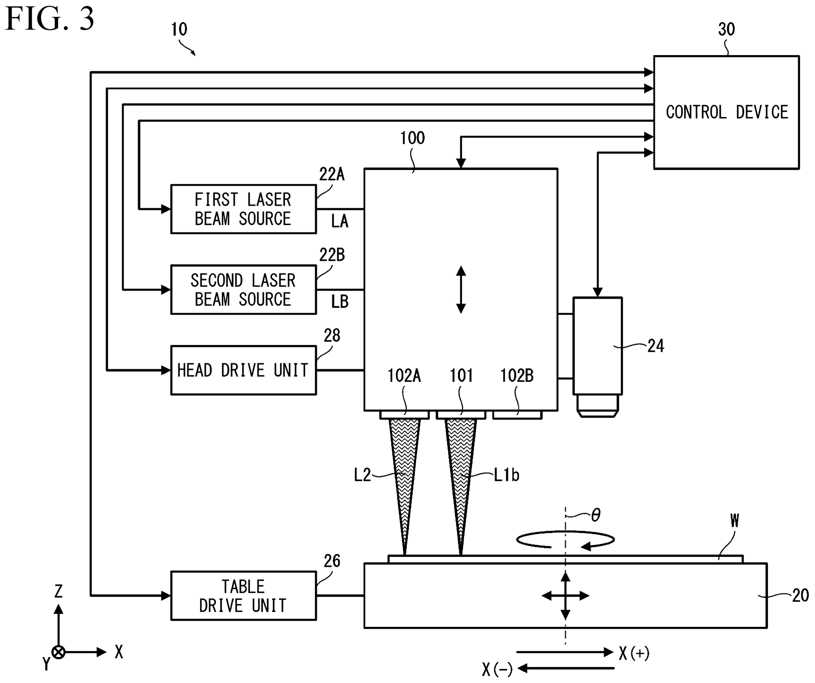

FIG. 3 is a schematic diagram showing an embodiment of a laser machining device. In FIG. 3, X, Y, and Z are three axes that are perpendicular to one another. In the present embodiment, it is assumed that a plane including the X and Y axes is a horizontal plane and X and Y directions are horizontal directions. Moreover, it is assumed that a Z direction is a vertical direction (an up-down direction).

As shown in FIG. 3, the laser machining device 10 of the present embodiment includes a table 20, a first laser beam source 22A, a second laser beam source 22B, a laser machining head 100, a microscope 24, a table drive unit 26, a head drive unit 28, and a control device 30.

The table 20 holds a wafer W. Moreover, the table 20 is driven by the table drive unit 26 under the control of the control device 30 and moves in the X and Y directions. The X direction is a direction of a machining feed operation. The street St to be machined is set parallel to the X direction. Moreover, under the control of the control device 30, the table 20 is driven by the table drive unit 26 to rotate around a θ axis. The θ axis passes through the center of the table 20 and is parallel to the Z axis.

The first laser beam source 22A supplies a laser beam LA for use in the edge cutting process to the laser machining head 100. This laser beam LA is a pulsed laser beam having conditions suitable for the edge cutting process, for example, conditions obtained by adjusting a wavelength, a pulse width, a repetition frequency, and the like.

The second laser beam source 22B supplies a laser beam LB for use in the hollowing process to the laser machining head 100. This laser beam LB is a pulsed laser beam having conditions suitable for the hollowing process, for example, conditions obtained by adjusting a wavelength, a pulse width, a repetition frequency, and the like.

The laser machining head 100 has a laser optical system and emits the first laser beams L1a and L1b for the edge cutting process and the second laser beam L2 for the hollowing process toward the wafer W on the table 20. The laser beams L1a and L1b, and L2 are emitted vertically downward toward the wafer W on the table 20.

The laser machining head 100 has three emission ports. One emission port is a first emission port 101 that emits the pair of first laser beams L1a and L1b for the edge cutting process. The remaining two emission ports are second emission ports 102A and 102B that emit the second laser beam L2 for the hollowing process. Hereinafter, as necessary, the second emission port 102A on one side (the left side of FIG. 3) will be referred to as a (2-1)^{th} emission port 102A, and the second emission port 102B on the other side (the right side of FIG. 3) will be referred to as a (2-2)^{th} emission port 102B, to distinguish between the two. The three emission ports, i.e., the first emission port 101, the (2-1)^{th} emission port 102A, and the (2-2)^{th} emission port 102B, are aligned and arranged in a row in the machining feed direction of the wafer W. Moreover, the first emission port 101 is arranged between the (2-1)^{th} emission port 102A and the (2-2)^{th} emission port 102B. That is, the (2-1)^{th} emission port 102A and the (2-2)^{th} emission port 102B, which are the emission ports of the laser beam for the hollowing process, are arranged on both sides of the first emission port 101, which is the emission port of the laser beam for the edge cutting process.

The second laser beam L2 for the hollowing process is emitted simultaneously or alternatively from the (2-1)^{th} emission port 102A and the (2-2)^{th} emission port 102B in accordance with a machining form. Details will be described below.

The laser machining head 100 is driven by the head drive unit 28 under the control of the control device 30 and moves in the Z direction.

Details of the laser machining head 100 including the laser optical system will be described below. In the present embodiment, the laser machining head 100 is an example of a laser machining unit.

The microscope 24 photographs the wafer W held on the table 20. The microscope 24 is fixed to the laser machining head 100 and moves together with the laser machining head 100. An image captured by the microscope 24 is output to the control device 30. The control device 30 performs alignment, kerf check, and the like on the basis of the image captured by the microscope 24.

The table drive unit 26 includes a guide mechanism configured to guide the table 20 in the X direction, a guide mechanism configured to guide the table 20 in the Y direction, bearings configured to rotatably support the table 20, and the like as guide mechanisms. Moreover, the table drive unit 26 includes a motor configured to drive the table 20 in the X direction, a motor configured to drive the table 20 in the Y direction, and a motor configured to rotate the table 20 as actuators. Moreover, the table drive unit 26 includes a sensor configured to detect a position of the table 20 in the X direction, a sensor configured to detect a position of the table 20 in the Y direction, and a sensor configured to detect a rotational position of the table 20 as sensors. The table drive unit 26 is an example of a machining feed unit.

The head drive unit 28 includes a guide mechanism configured to guide the laser machining head 100 in the Z direction, a motor configured to drive the laser machining head 100 in the Z direction, a sensor configured to detect the position of the laser machining head 100 in the Z direction, and the like.

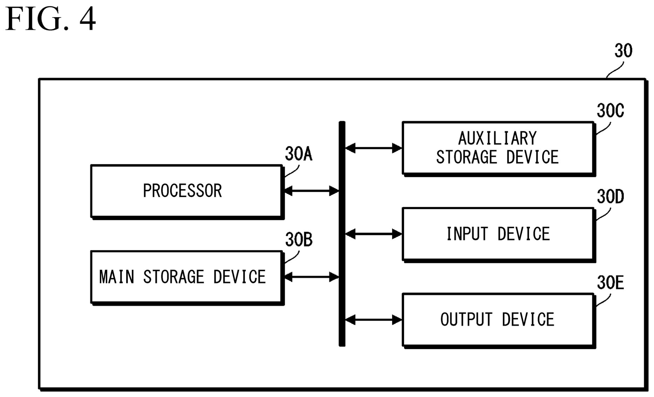

FIG. 4 is a schematic diagram showing an example of a hardware configuration of the control device.

The control device 30 includes a processor 30A, a main storage device 30B, an auxiliary storage device 30C, an input device 30D, an output device 30E, and the like. That is, the control device 30 is configured as a computer, and functions as the control device 30 when the computer executes a predetermined program. The processor 30A is configured as, for example, a central processing unit (CPU). The main storage device 30B is configured as, for example, a random-access memory (RAM). The auxiliary storage device 30C is configured as, for example, a hard disk drive (HDD), a solid-state drive (SSD), and the like. The input device 30D includes operation buttons, a keyboard, a touch panel, or the like. The output device 30E is configured as, for example, a display (a display device). The input device 30D and the output device 30E can also be configured as a touch panel display.

The control device 30 generally controls operations of the first laser beam source 22A, the second laser beam source 22B, the laser machining head 100, the microscope 24, the table drive unit 26, the head drive unit 28, and the like. The control device 30 is an example of a control unit.

### [Laser machining head]

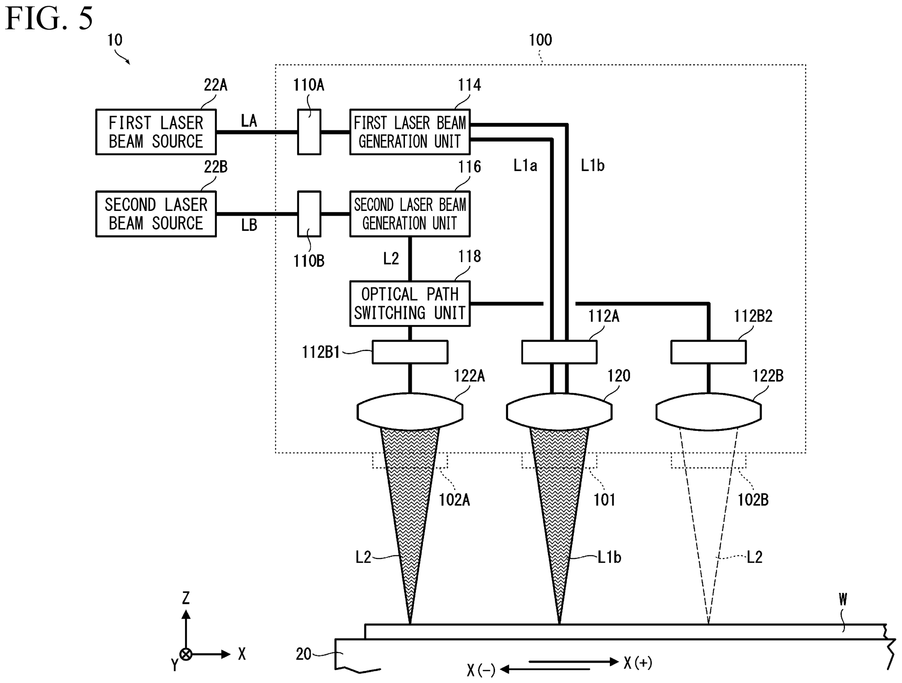

FIG. 5 is a schematic diagram showing an embodiment of the laser machining head.

As shown in FIG. 5, the laser machining head 100 includes a first safety shutter 110A, a second safety shutter 110B, a first laser beam generation unit 114, a second laser beam generation unit 116, an optical path switching unit 118, a first high-speed shutter 112A, two second high-speed shutters 112B1 and 112B2, a first condenser lens 120, two second condenser lenses 122A and 122B, and the like.

The first laser beam generation unit 114 and the first condenser lens 120 constitute a first laser optical system. A first laser optical system generates a pair of first laser beams L1a and L1b from the laser beam LA emitted from the first laser beam source 22A and emits the pair of first laser beams L1a and L1b from the first emission port 101. The second laser beam generation unit 116, the optical path switching unit 118, and the second condenser lenses 122A and 122B constitute a second laser optical system. A second laser optical system generates the second laser beam L2 from the laser beam LB emitted from the second laser beam source 22B and emits the second laser beam L2 from the (2-1)^{th} emission port 102A or the (2-2)^{th} emission port 102B.

The first safety shutter 110A is arranged on the optical path of the laser beam LA incident on the first laser beam generation unit 114 from the first laser beam source 22A. The first safety shutter 110A opens and closes the optical path under the control of the control device 30. When the first safety shutter 110A is closed, the incidence of the laser beam LA from the first laser beam source 22A to the laser machining head 100 is blocked. Moreover, thereby, the emission of the first laser beams L1a and L1b is stopped. The first safety shutter 110A functions as a shutter that closes a source of incidence of the first laser beams L1a and L1b.

The first laser beam generation unit 114 generates the pair of first laser beams L1a and L1b for the edge cutting process from the laser beam LA supplied from the first laser beam source 22A. The first laser beam generation unit 114 has a diffractive optical element (DOE) as a means for generating the pair of first laser beams L1a and L1b. The diffractive optical element is an optical element that can spatially split a laser beam by utilizing a diffraction phenomenon of light. The diffractive optical element can change the laser beam into various patterns and shapes. In the present embodiment, the pair of first laser beams L1a and L1b are generated so that a pair of spots are formed at a predetermined interval in the Y direction on the wafer W on the table 20 (see FIG. 2). In addition to the above, a refractive optical element (ROE), a Wollaston prism, and the like can also be used as the means for generating the pair of first laser beams L1a and L1b.

The pair of first laser beams L1a and L1b generated by the first laser beam generation unit 114 are radiated onto the wafer W on the table 20 via the first high-speed shutter 112A and the first condenser lens 120.

The first high-speed shutter 112A is arranged on the optical path of the first laser beams L1a and L1b incident on the first condenser lens 120 from the first laser beam generation unit 114. The first high-speed shutter 112A opens and closes the optical path under the control of the control device 30. By closing the first high-speed shutter 112A, the incidence of the first laser beams L1a and L1b on the first condenser lens 120 is blocked. Thereby, the emission of the first laser beams L1a and L1b is stopped. The first high-speed shutter 112A functions as a shutter that temporarily stops the emission of the first laser beams L1a and L1b. For this reason, the first high-speed shutter 112A is configured as a shutter that operates at a higher speed than the first safety shutter 110A. In addition, it is only necessary to arrange the first high-speed shutter 112A on the optical path between the first safety shutter 110A and the first emission port 101, and an arrangement position of the first high-speed shutter 112A is not particularly limited.

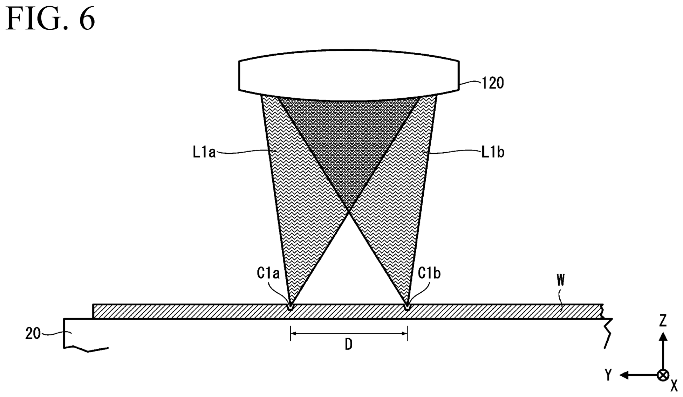

The first condenser lens 120 condenses the pair of first laser beams L1a and L1b generated by the first laser beam generation unit 114 at a predetermined position (focus) in the Z direction and radiates the pair of first laser beams L1a and L1b to the wafer W on the table 20. FIG. 6 is a conceptual diagram of irradiation of the first laser beam from the first condenser lens. The pair of first laser beams L1a and L1b are condensed with a predetermined interval D in the Y direction. This interval D becomes a formation interval of the two edge cutting grooves C1a and C1b.

The second safety shutter 110B is arranged on the optical path of the laser beam LB incident on the second laser beam generation unit 116 from the second laser beam source 22B. The second safety shutter 110B opens and closes the optical path under the control of the control device 30. By closing the second safety shutter 110B, the incidence of the laser beam LB from the second laser beam source 22B to the laser machining head 100 is blocked. Moreover, thereby, the emission of the second laser beam L2 is stopped. The second safety shutter 110B functions as a shutter that closes the source of incidence of the second laser beam L2.

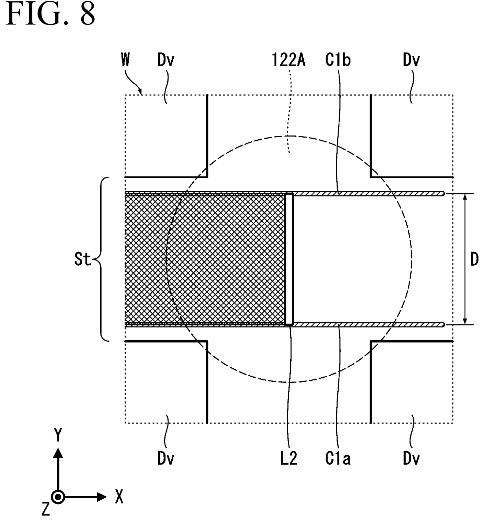

The second laser beam generation unit 116 generates the second laser beam L2 for the hollowing process from the laser beam LB supplied from the second laser beam source 22B. In the present embodiment, a laser beam having a linear or rectangular spot shape is generated as the second laser beam L2 for the hollowing process (see FIG. 8). The second laser beam generation unit 116 has, for example, a diffractive optical element (DOE), a mask, or the like as a means for generating a laser beam having a linear or rectangular spot shape. Moreover, in the present embodiment, a laser beam having a predetermined intensity distribution is generated as the second laser beam L2 for the hollowing process. As an example, a laser beam having a top hat-shaped intensity distribution (also referred to as a flat top) is generated. When the intensity distribution of the second laser beam L2 has a top hat shape, the bottom surface of the groove to which the hollowing process is applied can be machined flatly. The second laser beam generation unit 116 has, for example, a diffractive optical element (DOE), a refractive beam shaper, or the like as a means for converting the intensity distribution into a top hat shape. Moreover, the second laser beam generation unit 116 has a means for performing an intensity modulation process on the laser beam LB supplied from the second laser beam source 22B. As an example, an acoustic optical deflector (AOD) is provided. Under the control of the control device 30, the second laser beam generation unit 116 generates a second laser beam L2 of a predetermined intensity by performing an intensity modulation process on the laser beam LB supplied from the second laser beam source 22B. The second laser beam L2 generated by the second laser beam generation unit 116 is incident on the optical path switching unit 118.

The optical path switching unit 118 switches the optical path of the second laser beam L2 generated by the second laser beam generation unit 116. Specifically, the optical path switching unit 118 alternatively switches the optical path to any one of a first optical path for emitting the second laser beam L2 from the (2-1)^{th} emission port 102A, a second optical path for emitting the second laser beam L2 from the (2-2)^{th} emission port 102B, and a third optical path for emitting the second laser beams L2 from both the (2-1)^{th} emission port 102A and the (2-2)^{th} emission port 102B.

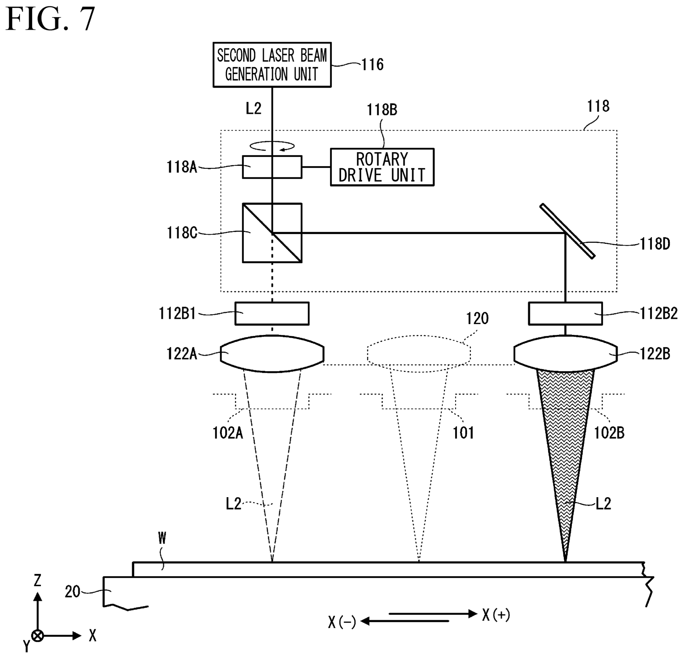

FIG. 7 is a schematic diagram showing an example of the configuration of the optical path switching unit.

As shown in FIG. 7, the optical path switching unit 118 includes a 1/2 wavelength plate (a λ/2 plate) 118A, a rotary drive unit 118B, a polarizing beam splitter (PBS) 118C, a mirror 118D, and the like. It is assumed that the laser beam LB that is linearly polarized light polarized in a predetermined polarization direction is emitted from the second laser beam source 22B. Therefore, the second laser beam L2 that is linearly polarized light polarized in a predetermined polarization direction is also emitted from the second laser beam generation unit 116.

The 1/2 wavelength plate 118A is arranged on the optical path of the second laser beam L2 introduced from the second laser beam generation unit 116 to the optical path switching unit 118. The 1/2 wavelength plate 118A switches a polarization direction of the second laser beam L2 by rotating around the optical axis of the second laser beam L2. In other words, the 1/2 wavelength plate 118A functions as a variable polarization rotator. The 1/2 wavelength plate 118A is rotatably supported by a support unit (not shown).

The rotary drive unit 118B rotates the 1/2 wavelength plate 118A. The rotary drive unit 118B rotates the 1/2 wavelength plate 118A among three rotation positions set at intervals of 22.5°. The three rotation positions are a first position, a second position, and a third position. When the 1/2 wavelength plate 118A is set at the first position, a polarization direction of the second laser beam L2 is set to a first direction. When the 1/2 wavelength plate 118A is set at the second position, the polarization direction of the second laser beam L2 is set to a second direction. The second direction is a direction rotated 45° from the first direction. When the 1/2 wavelength plate 118A is set at the third position, the polarization direction of the second laser beam L2 is set to a third direction. The third direction is a direction further rotated 45° from the second direction and is perpendicular to the first direction. The rotary drive unit 118B includes, for example, a motor, a rotary actuator, or the like.

The polarizing beam splitter 118C is arranged on the optical path of the second laser beam L2 transmitted through the 1/2 wavelength plate 118A. The polarizing beam splitter 118C splits the incident light into transmitted light and reflected light in accordance with a polarization state of the incident light. As described above, the second laser beam L2 transmitted through the 1/2 wavelength plate 118A is set in three polarization directions according to the position of the 1/2 wavelength plate 118A. When the second laser beam L2 whose polarization direction is a first polarization direction is incident, the polarizing beam splitter 118C transmits the second laser beam L2. Moreover, when the second laser beam L2 having a polarization direction in the third direction is incident, the polarizing beam splitter 118C reflects the light in the direction of the mirror 118D. Moreover, when light whose polarization direction is a second direction is incident, the polarizing beam splitter 118C equally splits the light into transmitted light and reflected light and emits the light. In this way, the polarizing beam splitter 118C functions as a beam splitter with an adjustable splitting ratio when used in combination with the 1/2 wavelength plate 118A.

When the second laser beam L2 is transmitted through the polarizing beam splitter 118C, the second laser beam L2 is incident on one second condenser lens 122A via one second high-speed shutter 112B1 and is emitted from the (2-1)^{th} emission port 102A.

When the second laser beam L2 is reflected by the polarizing beam splitter 118C, the second laser beam L2 is incident on the other second condenser lens 122B via the mirror 118D and the other second high-speed shutter 112B2 and is emitted from the (2-2)^{th} emission port 102B.

When the light is split into transmitted light and reflected light by the polarizing beam splitter 118C, the transmitted light is incident on one second condenser lenses 122A via one second high-speed shutters 112B1 and is emitted from the (2-1)^{th} emission port 102A. Moreover, the reflected light is incident on the other second condenser lenses 122B via the mirror 118D and the other second high-speed shutters 112B2 and is emitted from the (2-2)^{th} emission port 102B. In other words, the light is emitted from both second emission ports 102A and 102B.

In this way, the optical path switching unit 118 of the present embodiment selectively switches an optical path (an emission destination) of the second laser beam L2 by rotating the 1/2 wavelength plate 118A. In the case of the optical path switching unit 118 of the present embodiment, when the 1/2 wavelength plate 118A is set at the first position, the second laser beam L2 is emitted only from the (2-1)^{th} emission port 102A. Moreover, if the 1/2 wavelength plate 118A is set at the second position, the second laser beam L2 is emitted from both the (2-1)^{th} emission port 102A and the (2-2)^{th} emission port 102B. Moreover, if the 1/2 wavelength plate 118A is set at the third position, the second laser beam L2 is emitted only from the (2-2)^{th} emission port 102B. The optical path switching unit 118 controls the driving of the rotary drive unit 118B under the control of the control device 30 to switch the optical path of the second laser beam L2.

One second high-speed shutter 112B1 between the two second high-speed shutters 112B1 and 112B2 is arranged on the optical path of the second laser beam L2 incident on one second condenser lenses 122A. Moreover, the other second high-speed shutter 112B2 is arranged on the optical path of the second laser beam L2 incident on the other second condenser lenses 122B. Each of the second high-speed shutters 112B1 and 112B2 separately opens and closes an optical path under the control of the control device 30. By closing the second high-speed shutters 112B1 and 112B2, the incidence of the second laser beam L2 on the second condenser lenses 122A and 122B is blocked. Thereby, the emission of the second laser beam L2 is stopped. Each of the second high-speed shutters 112B1 and 112B2 functions as a shutter that temporarily stops the emission of the second laser beam L2. For this reason, each of the second high-speed shutters 112B1 and 112B2 is configured as a shutter that operates at a higher speed than the second safety shutter 110B. Hereinafter, as necessary, one of the second high-speed shutters 112B1 will be referred to as a (2-1)^{th} high-speed shutter 112B1, and the other second high-speed shutter 112B2 will be referred to as a (2-2)^{th} high-speed shutter 112B2, to distinguish between the two. In addition, the arrangement positions of the second high-speed shutters 112B1 and 112B2 are not particularly limited as long as they are arranged on the optical path between the polarizing beam splitter 118C and the second emission ports 102A and 102B.

The two second condenser lenses 122A and 122B each condense the second laser beam L2 generated by the second laser beam generation unit 116 at a predetermined position (a focus) in the Z direction. Hereinafter, one second condenser lens 122A will be referred to as the (2-1)^{th} condenser lens 122A, and the other second condenser lens 122B will be referred to as the (2-2)^{th} condenser lens 122B, as necessary, to distinguish between the two.

FIG. 8 is a conceptual diagram of the irradiation of the second laser beam from the second condenser lens.

As described above, in the present embodiment, the second laser beam L2 forms a rectangular spot to perform the hollowing process. The spot is formed in correspondence with the distance D between the two edge cutting grooves C1a and C1b formed by the pair of first laser beams L1a and L1b. In other words, the spot is formed with a width for enabling the inside of the two edge cutting grooves C1a and C1b to be hollowed out at once. In the present embodiment, the spot is formed so that the long side of the rectangle is perpendicular to the machining feed direction (the X direction). Moreover, the spot is formed so that the length of the long side of the rectangle corresponds to the distance D between the two edge cutting grooves C1a and C1b.

The two second condenser lenses 122A and 122B are aligned and arranged in a row along the machining feed direction of the wafer W together with the first condenser lens 120. Moreover, the two second condenser lenses 122A and 122B are arranged to sandwich the first condenser lens 120 therebetween. Specifically, in FIG. 5, the (2-1)^{th} condenser lens 122A, the first condenser lens 120, and the (2-2)^{th} condenser lens 122B are aligned and arranged in a row in this order from left to right in the drawing (the X (+) direction).

The pair of first laser beams L1a and L1b that have passed through the first condenser lens 120 are radiated vertically downward from the first emission port 101 toward the wafer W on the table 20. Moreover, the second laser beam L2 that has passed through the (2-1)^{th} condenser lens 122A is radiated vertically downward from the (2-1)^{th} emission port 102A toward the wafer W on the table 20. Moreover, the second laser beam L2 that has passed through the (2-2)^{th} condenser lens 122B is radiated vertically downward from the (2-2)^{th} emission port 102B toward the wafer W on the table 20.

In the present embodiment, the configuration in which the pair of first laser beams L1a and L1b are radiated onto the wafer W on the table 20 via the first condenser lens 120 to machine the two edge cutting grooves C1a and C1b is an example of a first machining unit. Also, the configuration in which the second laser beam L2 is radiated onto the wafer W on the table 20 via the second condenser lenses 122A and 122B to perform a hollowing process between the two edge cutting grooves C1a and C1b is an example of two second machining units.

### [Function of laser machining device]

### [Basic operation]

As shown in FIG. 1, the laser machining device 10 machines a predetermined groove (a wiring layer removal groove C) for each street St in the semiconductor wafer W on which a large number of devices Dv are formed and removes the wiring layer including the low-k film from the street St.

The wiring layer removal groove C is machined when the wafer W is fed in the X direction (the machining feed direction). As described below, in the present embodiment, multi-path machining for applying a plurality of machining feed operations to one street St and machining the required wiring layer removal groove C is performed.

The wiring layer removal grooves C are machined in order from the street St positioned at one end in the Y direction. When the machining for one street St is completed, the wafer W is fed in the Y direction (the index feed operation) and the next street St is machined. When the machining for all the streets St extending in the first direction (the X direction in FIG. 1) is completed, the wafer W is rotated by 90°. Thereby, the streets St extending in the second direction (the Y direction in FIG. 1) are arranged in the machining feed direction. In a similar procedure, the wiring layer removal grooves C are machined along all streets St extending in the second direction.

### [Details of wiring layer removal groove machining operation]

As described above, in the laser machining device 10 of the present embodiment, the required wiring layer removal groove C is machined by applying a plurality of machining feed operations with respect to one street St. Hereinafter, as an example, a case where a single street St is machined by applying two machining feed operations, i.e., a case where machining is performed in one round trip, will be described.

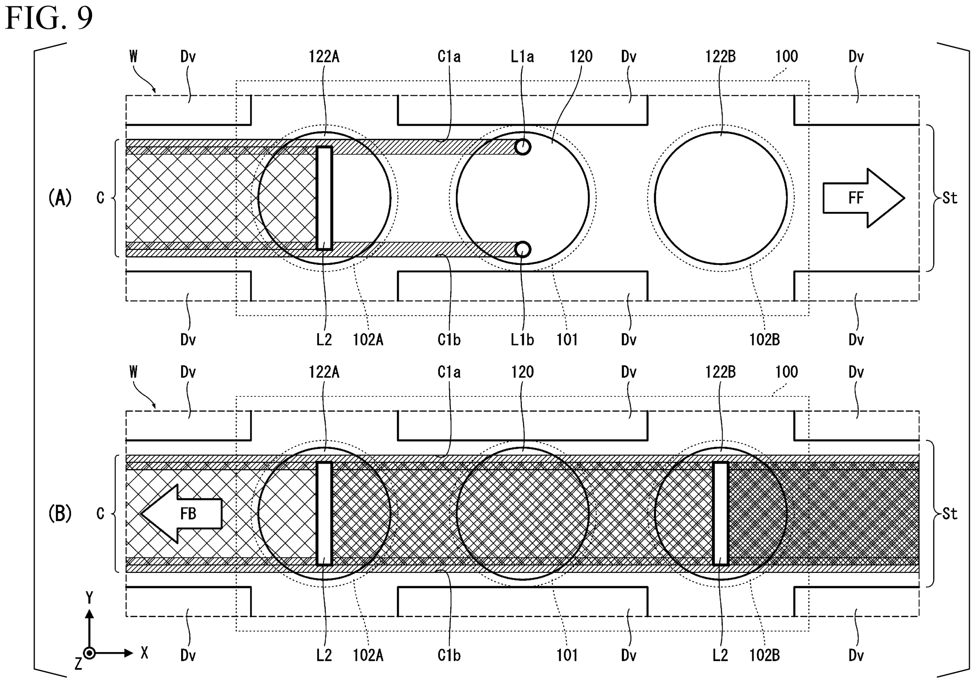

FIG. 9 is a conceptual diagram of the machining of the wiring layer removal groove. FIG. 9(A) shows a machining state on the forward path (the first machining feed operation). In FIG. 9(A), an arrow indicated by reference sign FF is a machining progress direction (a machining direction) on the forward path. The machining progress direction on the forward path is from left to right in the drawing. The wafer W is fed in the direction from right to left in the drawing. FIG. 9(B) shows a machining state on the return path (the second machining feed operation). In FIG. 9(B), an arrow indicated by reference sign FB is the machining progress direction on the return path. The machining progress direction on the return path is a direction opposite to the machining feed direction on the forward path, from right to left in the drawing. The wafer W is fed in the direction from left to right in the drawing.

As shown in FIG. 9(A), while the pair of first laser beams L1a and L1b are emitted from the first emission port 101 on the forward path and the two edge cutting grooves C1a and C1b are machined on the wafer W, the second laser beam L2 is emitted from the (2-1)^{th} emission port 102A and an area between the two edge cutting grooves C1a and C1b is hollowed out. That is, the second laser beam L2 is emitted from the (2-1)^{th} emission port 102A positioned on the downstream side in the machining progress direction between the (2-1)^{th} emission port 102A and the (2-2)^{th} emission port 102B and the area between the two edge cutting grooves C1a and C1b is hollowed out.

On the other hand, as shown in FIG. 9(B), on the return path, the second laser beam L2 is emitted from both the (2-1)^{th} emission port 102A and the (2-2)^{th} emission port 102B and the area between the two edge cutting grooves C1a and C1b is hollowed out.

In this way, the machining quality can be improved by performing the hollowing process in a plurality of steps (two steps in this example). Moreover, in the second and subsequent machining feed operations, machining is performed by emitting the second laser beam L2 from both the (2-1)^{th} emission port 102A and the (2-2)^{th} emission port 102B, thereby improving throughput. Therefore, according to the machining method of the present embodiment, it is possible to efficiently machine the wafer W while maintaining the machining quality.

The control device 30 controls the intensities of the second laser beams L2 emitted from the two second emission ports 102A and 102B so that the second laser beam L2 of the same intensity is radiated onto the wafer W on the forward path and the return path. The intensities of the second laser beams L2 emitted from the two second emission ports 102A and 102B are adjusted by the second laser beam generation unit 116. Therefore, the control device 30 controls the second laser beam generation unit 116 to control the intensities of the second laser beams L2 emitted from the two second emission ports 102A and 102B. Specifically, on the forward path, the second laser beam L2 with a first intensity is emitted from the (2-1)^{th} emission port 102A and the hollowing process is performed. Moreover, on the return path, the second laser beams L2 with the first intensity are emitted from both the (2-1)^{th} emission port 102A and the (2-2)^{th} emission port 102B and the hollowing process is performed.

### [Machining flow (laser machining method)]

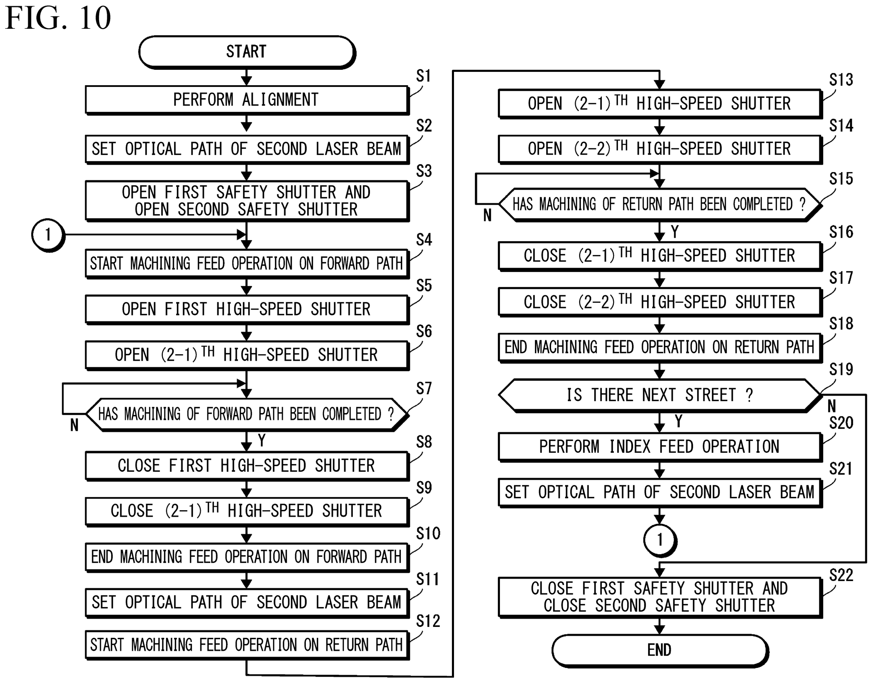

FIG. 10 is a flowchart showing a flow of a machining process of the laser machining device of the present embodiment.

In addition, it is assumed that the wafer W is held on the table 20, and that the laser beams LA and LB is supplied from the first laser beam source 22A and the second laser beam source 22B to the laser machining head 100. Moreover, it is assumed that the first safety shutter 110A, the second safety shutter 110B, the first high-speed shutter 112A, and two second high-speed shutters 112B1 and 112B2 are closed.

First, alignment is performed (step S1). That is, the machining position is detected and aligned. The alignment is performed on the basis of an image captured by the microscope 50.

Subsequently, the optical path of the second laser beam L2 is set (step S2). That is, the optical path of the second laser beam L2 on the forward path is set. As described above, on the forward path, the second laser beam L2 is emitted only from the (2-1)^{th} emission port 102A positioned on the downstream side in the machining progress direction. The control device 30 sets the optical path switching unit 118 so that the second laser beam L2 is emitted only from the (2-1)^{th} emission port 102A. Specifically, the rotary drive unit 118B is controlled to set the 1/2 wavelength plate 118A at the first position.

When the setting of the optical path of the second laser beam L2 is completed, the first safety shutter 110A and the second safety shutter 110B are opened (step S3). Thereby, the laser beams LA and LB from the first laser beam source 22A and the second laser beam source 22B are introduced into the laser machining head 100. However, because the first high-speed shutter 112A and the two second high-speed shutters 112B1 and 112B2 are closed, the first laser beams L1a and L1b and the second laser beam L2 are not emitted.

When the first safety shutter 110A and the second safety shutter 110B are opened, the machining feed operation is started on the forward path (step S4). Thereby, the machining feed operation is applied to the wafer W along the street St. The feed direction of the wafer W on the forward path is the X (-) direction in FIG. 1.

The first high-speed shutter 112A is opened (step S5). Thereby, a pair of first laser beams L1a and L1b are emitted from the first emission port 101 and radiated onto the wafer W on the table 20. Thereby, the two edge cutting grooves C1a and C1b are machined along the street St. The machining progress direction is the X (+) direction in FIG. 1. The two edge cutting grooves C1a and C1b are machined at a predetermined interval D and machined at a predetermined depth.

Subsequently, the (2-1)^{th} high-speed shutter 112B1 is opened (step S6). Thereby, the second laser beam L2 is emitted from the (2-1)^{th} emission port 102A via the (2-1)^{th} condenser lens 122A. As described above, the (2-1)^{th} emission port 102A is an emission port positioned on the downstream side in the machining progress direction. The second laser beam L2 emitted from the (2-1)^{th} emission port 102A is radiated between the two edge cutting grooves C1a and C1b that have been machined. Thereby, the area between the two edge cutting grooves C1a and C1b that have been machined is hollowed out.

Subsequently, it is determined whether or not the machining of the forward path has been completed (step S7). In other words, it is determined whether or not the machining has been completed to the end of the forward path in the feed direction. When it is determined that the machining of the forward path has been completed, the first high-speed shutter 112A is first closed (step S8). Thereby, the irradiation of the first laser beams L1a and L1b is stopped. Moreover, the edge cutting process is stopped. Subsequently, the (2-1)^{th} high-speed shutter 112B1 is closed (step S9). Thereby, the irradiation of the second laser beam L2 is stopped. Moreover, thereby, the hollowing process is stopped. Subsequently, the machining feed operation on the forward path is stopped (step S10). Thereby, the movement of the wafer W is stopped.

The above series of steps complete the machining process on the forward path. Subsequently, machining on the return path is performed.

First, the optical path of the second laser beam L2 is set (step S11). That is, the optical path of the second laser beam L2 on the return path is set. As described above, on the return path, the second laser beams L2 are emitted from both the (2-1)^{th} emission port 102A and the (2-2)^{th} emission port 102B. The control device 30 sets the optical path switching unit 118 so that the second laser beams L2 are emitted from both the (2-1)^{th} emission port 102A and the (2-2)^{th} emission port 102B. Specifically, the rotary drive unit 118B is controlled to set the 1/2 wavelength plate 118A at the second position. Thereby, the second laser beam L2 generated by the second laser beam generation unit 116 is split into two and the second laser beams L2 can be emitted from both the (2-1)^{th} emission port 102A and the (2-2)^{th} emission port 102B.

If the setting of the optical path of the second laser beam L2 is completed, the machining feed on the return path is started (step S12). Thereby, the machining feed operation is applied to the wafer W along the street St. The feed direction of the wafer W on the return path is the X (+) direction in FIG. 1. Moreover, thereby, the area between the two edge cutting grooves C1a and C1b that have been machined is hollowed out by the second laser beam L2 emitted from both of the two second emission ports 102A and 102B. The machining progress direction is the X (-) direction in FIG. 1.

Subsequently, the (2-1)^{th} high-speed shutter 112B1 is opened (step S13). Thereby, the second laser beam L2 is emitted from the (2-1)^{th} emission port 102A via the (2-1)^{th} condenser lens 122A. The second laser beam L2 emitted from the (2-1)^{th} emission port 102A is radiated between the two edge cutting grooves C1a and C1b that have been machined. Thereby, the area between the two edge cutting grooves C1a and C1b that have been machined is further hollowed out.

Subsequently, the (2-2)^{th} high-speed shutter 112B2 is opened (step S14). Thereby, the second laser beam L2 is emitted from the (2-2)^{th} emission port 102B via the (2-2)^{th} condenser lens 122B. The second laser beam L2 emitted from the (2-2)^{th} emission port 102B is radiated between the two edge cutting grooves C1a and C1b that have been machined. Thereby, the area between the two edge cutting grooves C1a and C1b that have been machined is further hollowed out.

Subsequently, it is determined whether or not the machining on the return path has been completed (step S15). In other words, it is determined whether or not the machining has been completed to the end of the feed direction on the return path. When the machining on the return path has been completed and stopped, the (2-1)^{th} high-speed shutter 112B1 is first closed (step S16). Thereby, the emission of the second laser beam L2 from the (2-1)^{th} emission port 102A is stopped. Moreover, thereby, the hollowing process by the second laser beam L2 emitted from the (2-1)^{th} emission port 102A is stopped. Subsequently, the (2-2)^{th} high-speed shutter 112B2 is closed (step S17). Thereby, the emission of the second laser beam L2 from the (2-2)^{th} emission port 102B is stopped. Moreover, thereby, the hollowing process using the second laser beam L2 emitted from the (2-2)^{th} emission port 102B is stopped. Subsequently, the machining feed operation on the return path ends (step S18). Thereby, the movement of the wafer W is stopped.

In the above series of steps, machining on the return path is completed. Simultaneously with this, the machining of the wiring layer removal groove C along the street St to be machined is completed. Subsequently, it is determined whether or not there is the next street St to be machined (step S19).

When there is the next street St to be machined, the next street St is machined. In this case, first, the wafer W is fed in the Y direction (in an index feed operation) toward the position of the next street St to be machined (step S20). The wafer W is applied to the index feed operation with an amount of feed corresponding to the spacing between the streets St (the spacing between the chips). Subsequently, the optical path of the second laser beam L2 is set (step S21). That is, the optical path of the second laser beam L2 on the forward path is set. Subsequently, the process from step S4 to step S19 is performed and the wiring layer removal grooves C are machined along the streets St.

On the other hand, when there is no next street St to be machined, i.e., when the machining for all streets St is completed, the first safety shutter 110A and the second safety shutter 110B are closed (step S22).

Subsequently, the wafer W is collected from the table 20 and the machining of the wafer W is completed.

In this way, in the laser machining device 10 of the present embodiment, two machining feed operations are applied to machine the required wiring layer removal grooves C along the streets St. Also, while the edge cutting process is performed with the pair of first laser beams L1a and L1b, the second laser beam L2 is emitted from the second emission port positioned on the downstream side in the machining progress direction to perform the hollowing process in a first machining feed operation (on the forward path). In a second machining feed operation (on the return path), the second laser beams L2 are emitted from both of the two second emission ports 102A and 102B to perform the hollowing process. Thereby, it is possible to efficiently machine the wafer W while maintaining machining quality.

Although an example in which two machining feed operations are applied for machining has been described, a configuration in which three or more machining feed operations are applied for machining may be adopted.

### [Modification example]

### [Setting of intensity of second laser beam]

When the hollowing process is performed, the intensity of the second laser beam L2 may be changed for each machining feed operation. For example, when the wiring layer removal groove C is machined in one round trip, the second laser beam L2 with a first intensity is emitted from the (2-1)^{th} emission port 102A on the forward path. On the other hand, on the return path, the second laser beams L2 with a second intensity different from the first intensity are emitted from both the (2-1)^{th} emission port 102A and the (2-2)^{th} emission port 102B to perform the hollowing process. Thereby, for example, it is possible to set the intensity of the second laser beam L2 to be radiated in accordance with a layer to be machined (a layer to be removed), a depth, or the like.

Likewise, when the second laser beams L2 are emitted from the two second emission ports 102A and 102B, in other words, in the second and subsequent machining feed operations, the second laser beams L2 with different intensities may be emitted from the two second emission ports 102A and 102B. In this case, the optical path switching unit 118 adjusts the amount of splitting of the second laser beam L2. The amount of splitting is adjusted by rotating the 1/2 wavelength plate 118A.

### [Second embodiment]

As described above, when a groove is machined along a street and a wiring layer including a low-k film is removed from the street, the occurrence of delamination can be suppressed by machining the groove in a machining process divided into the edge cutting process and the hollowing process. This machining method has a configuration in which the area between two grooves machined by the edge cutting process is hollowed out by the hollowing process. Therefore, it is basically necessary to perform the edge cutting process before the hollowing process. However, if delamination is not caused, it is also possible to perform the hollowing process before the edge cutting process. Therefore, in the present embodiment, the hollowing process is performed before the edge cutting process under predetermined conditions. Specifically, a laser beam with an intensity that does not cause delamination is radiated and the hollowing process is performed before the edge cutting process. In addition, in the present embodiment, a normal hollowing process, i.e., a machining process for hollowing out the area between the two edge cutting grooves C1a and C1b that have been machined, is also performed. Therefore, the hollowing process is performed before and after the edge cutting process.

In addition, the basic configuration of the device is the same as that of the laser machining device 10 of the first embodiment and the aspect of machining control (control of irradiation of the first laser beam and the second laser beam) is different. Therefore, only the aspect of machining control will be described here.

### [Basic operation]

Here, a so-called single-path machining case will be described as an example, in which a required wiring layer removal groove C (a groove having a predetermined width and depth) is machined along the street St by one machining feed operation.

In this case, an index feed operation is applied every time a machining feed operation is applied. Therefore, the wiring layer removal groove C is machined along different streets St on the forward path and the return path.

### [Irradiation control of second laser beam]

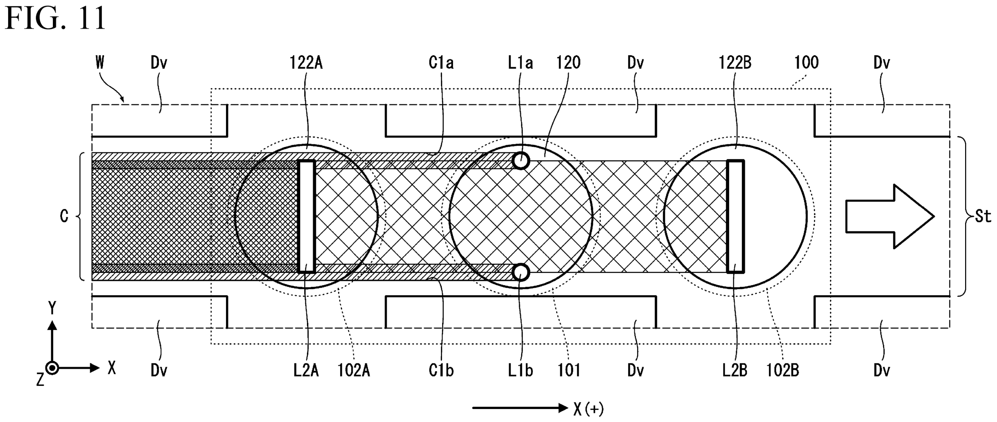

As described above, in the present embodiment, the hollowing process is performed before and after the edge cutting process. Therefore, the second laser beams L2 are emitted from the two second emission ports 102A and 102B to perform machining. Hereinafter, the second laser beam emitted from the (2-1)^{th} emission port 102A will be referred to as a (2-1)^{th} laser beam L2A, and the second laser beam emitted from the (2-2)^{th} emission port 102B will be referred to as a (2-2)^{th} laser beam L2B, as necessary, to distinguish between the two (see FIG. 11).

The intensities of the second laser beams L2A and L2B emitted from the (2-1)^{th} emission port 102A and the (2-2)^{th} emission port 102B are controlled by the second laser beam generation unit 116 and the optical path switching unit 118. That is, an overall intensity is controlled by the second laser beam generation unit 116, and the amount of splitting is controlled by the optical path switching unit 118. The overall intensity is controlled, for example, by an acoustic optical element provided in the second laser beam generation unit 116. The amount of splitting is controlled by rotating the 1/2 wavelength plate 118A (see FIG. 7). The rotary drive unit 118B, for example, rotates the 1/2 wavelength plate 118A between two rotation positions, i.e., rotation position A and rotation position B. If the 1/2 wavelength plate 118A is set at rotation position A, the incident light is split into transmitted light and reflected light at a ratio of A1:B1 in the polarizing beam splitter 118C. For example, the incident light is split into transmitted light and reflected light so that A1 > B1. On the other hand, when the 1/2 wavelength plate 118A is set at rotation position B, the incident light is split into transmitted light and reflected light at a ratio of A2:B2 in the polarizing beam splitter 118C. For example, the incident light is split into transmitted light and reflected light so that A2 < B2.

When the 1/2 wavelength plate 118A is set at rotation position A, the second laser beams L2A and L2B are emitted from both the (2-1)^{th} emission port 102A and the (2-2)^{th} emission port 102B, and the second laser beam L2A with a relatively high intensity is emitted from the (2-1)^{th} emission port 102A. That is, the intensity of the (2-1)^{th} laser beam L2A is higher than the intensity of the (2-2)^{th} laser beam L2B. The intensity of the (2-2)^{th} laser beam L2B at this time is an intensity at which delamination does not occur. That is, the lower intensity, in other words, the intensity with the smaller amount of splitting, is set to an intensity lower than the intensity at which delamination occurs.

On the other hand, when the 1/2 wavelength plate 118A is set at rotation position B, the second laser beams L2A and L2B are emitted from both the (2-1)^{th} emission port 102A and the (2-2)^{th} emission port 102B, and the second laser beam L2B with a relatively high intensity is emitted from the (2-2)^{th} emission port 102B. That is, the intensity of the (2-1)^{th} laser beam is lower than the intensity of the (2-2)^{th} laser beam. The intensity of the (2-1)^{th} laser beam L2A at this time is an intensity at which delamination does not occur. That is, the lower intensity, in other words, the intensity with the smaller amount of splitting, is set to an intensity lower than the intensity at which delamination occurs.

The rotation position of the 1/2 wavelength plate 118A is switched in accordance with the machining progress direction. That is, the second emission port positioned on the downstream side in the machining progress direction is set to emit a second laser beam with a higher intensity than the second emission port positioned on the upstream side. For example, when the machining progress direction is the X (+) direction in FIG. 7 (from left to right in FIG. 7), the 1/2 wavelength plate 118A is set at rotation position A. Thereby, the (2-1)^{th} laser beam L2A with a first intensity is emitted from the (2-1)^{th} emission port 102A on the downstream side, and the (2-2)^{th} laser beam L2B with a second intensity lower than the first intensity is emitted from the (2-2)^{th} emission port 102B on the upstream side. Moreover, for example, when the machining progress direction is the X (-) direction in FIG. 7 (from right to left in FIG. 7), the 1/2 wavelength plate 118A is set at rotation position B. Thereby, the (2-2)^{th} laser beam L2B with the first intensity is emitted from the (2-2)^{th} emission port 102B on the downstream side and the (2-1)^{th} laser beam L2A with the second intensity lower than the first intensity is emitted from the (2-1)^{th} emission port 102A on the upstream side.

In this way, the second laser beam with the first intensity is emitted from the second emission port positioned on the downstream side in the machining progress direction and the second laser beam with the second intensity is emitted from the second emission port positioned on the upstream side so that the wiring layer removal groove C is machined. The second laser beam emitted from the second emission port positioned on the upstream side is a laser beam for performing the hollowing process before the edge cutting process, and is radiated with an intensity that does not cause delamination.

### [Details of wiring layer removal groove machining operation (laser machining method)]

As described above, in the laser machining device 10 of the present embodiment, one machining feed operation is applied for one street St to machine the required wiring layer removal groove C, so-called single-path machining is performed.

FIG. 11 is a conceptual diagram of the machining of the wiring layer removal groove. FIG. 11 shows an example of machining in the X (+) direction (the direction from left to right in FIG. 11). In this case, the wafer W is fed from right to left in the drawing (a feed operation is applied in a direction opposite to the X (+) direction).

As shown in FIG. 11, while a pair of first laser beams L1a and L1b are emitted from the first emission port 101 to perform the edge cutting process, second laser beams L2A and L2B are emitted from both the (2-1)^{th} emission port 102A and the (2-2)^{th} emission port 102B to perform the hollowing process.

Here, the (2-1)^{th} laser beam L2A emitted from the (2-1)^{th} emission port 102A positioned on the downstream side of the first emission port 101 in the machining progress direction (the X (+) direction in FIG. 11) machines the area between the two edge cutting grooves C1a and C1b that have been machined. On the other hand, the (2-2)^{th} laser beam L2B emitted from the (2-2)^{th} emission port 102B positioned on the upstream side of the first emission port 101 in the machining progress direction machines the area between the two edge cutting grooves C1a and C1b before they are machined. In this case, the machining is performed with an intensity that does not cause delamination.

In this way, it is possible to efficiently machine the wafer W while maintaining the machining quality by performing the hollowing process before the edge cutting process.

### [Flow of machining process (laser machining method)]

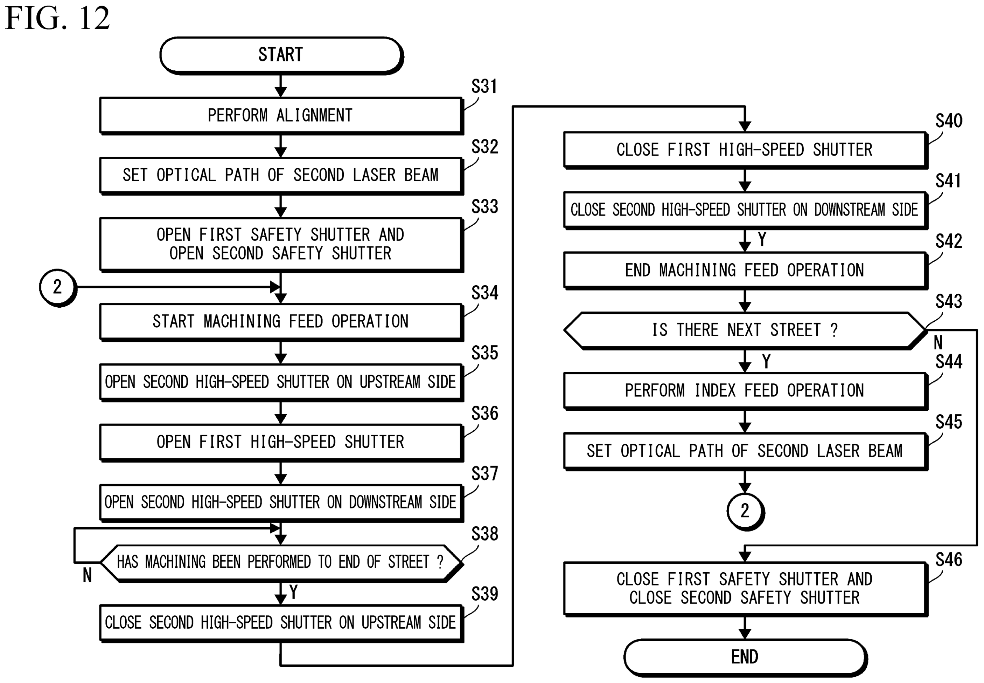

FIG. 12 is a flowchart showing a flow of a machining process of the laser machining device of the present embodiment.

In addition, it is assumed that the wafer W is held on the table 20, and the laser beams LA and LB are supplied from the first laser beam source 22A and the second laser beam source 22B to the laser machining head 100. Moreover, it is assumed that the first safety shutter 110A and the second safety shutter 110B as well as the first high-speed shutter 112A and the two second high-speed shutters 112B1 and 112B2 are closed.

First, alignment is performed (step S31). That is, the machining position is detected and aligned. The alignment is performed on the basis of an image captured by the microscope 50.

Subsequently, optical paths (amounts of splitting) of the second laser beams L2A and L2B are set (step S32). Here, the optical paths are set so that the second laser beam with a first intensity are emitted from the second emission port positioned on the downstream side and the second laser beam with a second intensity is emitted from the second emission port positioned on the upstream side in the machining progress direction. As described above, the second intensity is lower than the first intensity and is an intensity that does not cause delamination.

For example, in FIG. 7, when the machining progress direction is the X (+) direction, the optical paths of the second laser beams L2A and L2B are set so that the (2-1)^{th} laser beam L2A with the first intensity is emitted from the (2-1)^{th} emission port 102A and the (2-2)^{th} laser beam L2B with the second intensity is emitted from the (2-2)^{th} emission port 102B. Moreover, for example, when the machining progress direction is the X (-) direction, the optical paths of the second laser beams L2A and L2B are set so that the (2-2)^{th} laser beam L2B with the first intensity is emitted from the (2-2)^{th} emission port 102B and the (2-1)^{th} laser beam L2A with the second intensity is emitted from the (2-1)^{th} emission port 102A.

When the setting of the optical path of the second laser beam L2 is completed, the first safety shutter 110A and the second safety shutter 110B are opened (step S33). Thereby, the laser beams LA and LB from the first laser beam source 22A and the second laser beam source 22B are introduced into the laser machining head 100. However, because the first high-speed shutter 112A and the two second high-speed shutters 112B1 and 112B2 are closed, the first laser beams L1a and L1b and the second laser beam L2 are not emitted.

When the first safety shutter 110A and the second safety shutter 110B are opened, the machining feed operation is started (step S34). As a result, the machining feed operation is applied to the wafer W along the street St.

After the machining feed operation starts, the second high-speed shutter positioned on the upstream side in the machining progress direction is first opened (step S35). For example, in FIG. 7, when the machining progress direction is the X (+) direction, the (2-2)^{th} high-speed shutter 112B2 is opened. Thereby, the second laser beam L2 is emitted from the (2-2)^{th} emission port positioned on the upstream side of the machining progress direction. For example, in FIG. 7, when the machining progress direction is the X (+) direction, the second laser beam L2 is emitted from the (2-2)^{th} emission port 102B.

Subsequently, the first high-speed shutter 112A is opened (step S36). Thereby, a pair of first laser beams L1a and L1b are emitted from the first emission port 101.

Subsequently, the second high-speed shutter positioned on the downstream side of the machining progress direction is opened (step S37). For example, in FIG. 7, when the machining progress direction is the X (+) direction, the (2-1)^{th} high-speed shutter 112B1 is opened. Thereby, the second laser beam L2 is emitted from the (2-2)^{th} emission port positioned on the downstream side of the machining progress direction. For example, in FIG. 7, when the machining progress direction is the X (+) direction, the second laser beam L2 is emitted from the (2-1)^{th} emission port 102A.

The laser beam emitted from each emission port is radiated to a predetermined position on the street St of the wafer W on the table 20. Moreover, thereby, the wiring layer removal groove C is machined in the wafer W along the street St.

Here, the wiring layer removal groove C is machined to a predetermined width and a predetermined depth along the street St by machining two edge cutting grooves C1a and C1b along the street St and hollowing out the area between the two edge cutting grooves C1a and C1b. The two edge cutting grooves C1a and C1b are machined by a pair of first laser beams L1a and L1b emitted from the first emission port 101. Also, the area between the two edge cutting grooves C1a and C1b is machined by the second laser beams L2A and L2B emitted from the two second emission ports 102A and 102B. The two second emission ports 102A and 102B are arranged in front of and behind the first emission port 101 in the machining feed direction. Therefore, the second laser beam emitted from the second emission port positioned on the upstream side in the machining progress direction hollows out the area between the two edge cutting grooves C1a and C1b before the two edge cutting grooves C1a and C1b are machined. However, as described above, because the second laser beam adjusted to a predetermined intensity (the second intensity) is emitted from the second emission port positioned on the upstream side in the machining progress direction, the occurrence of delamination can be suppressed.

Subsequently, it is determined whether or not the machining has been completed to the end of the street St (step S38). When it is determined that the machining has been completed to the end of the street St, the second high-speed shutter positioned on the upstream side of the machining progress direction is first closed (step S39). For example, in FIG. 7, when the machining progress direction is the X (+) direction, the (2-2)^{th} high-speed shutter 112B2 is closed. Thereby, the emission of the second laser beam L2 from the (2-2)^{th} emission port positioned on the upstream side of the machining progress direction is stopped. Thereby, the preceding hollowing process ends.

Subsequently, the first high-speed shutter 112A is closed (step S40). Thereby, the emission of the pair of first laser beams L1a and L1b is stopped. Moreover, thereby, the edge cutting process ends.

Subsequently, the second high-speed shutter positioned on the downstream side of the machining progress direction is opened (step S41). For example, in FIG. 7, when the machining progress direction is the X (+) direction, the (2-1)^{th} high-speed shutter 112B1 is opened. Thereby, the emission of the second laser beam L2 from the (2-2)^{th} emission port positioned on the downstream side in the machining progress direction is stopped. Thereby, the subsequent hollowing process ends.

Then, the machining feed operation is completed (step S42). Thereby, the movement of the wafer W is stopped.

In the above series of steps, the machining of the wiring layer removal groove C for one street St is completed. Subsequently, it is determined whether or not there is the next street St to be machined (step S43).

When there is the next street St to be machined, the next street St is machined. In this case, first, a feed operation (an index feed operation) is performed for the wafer W in the Y direction toward the position of the next street St to be machined (step S44). The index feed operation is applied to the wafer W with an amount of feed corresponding to the spacing between the streets St (the spacing between the chips). Subsequently, the optical path (an amount of splitting) of the second laser beam L2 is set (step S45). That is, the optical path is set so that the second laser beam with the first intensity is emitted from the second emission port positioned on the downstream side in the machining progress direction and the second laser beam with the second intensity is emitted from the second emission port positioned on the upstream side. Subsequently, the process of steps S34 to S43 is performed and a wiring layer removal groove C is machined along the street St.

On the other hand, when there is no next street St to be machined, i.e., when the machining of all the streets St is completed, the first safety shutter 110A and the second safety shutter 110B are closed (step S46).

Subsequently, the wafer W is collected from the table 20 and a process for machining the wafer W is completed.

In this way, in the laser machining device of the present embodiment, by performing the hollowing process before the edge cutting process, it is possible to efficiently machine the wafer W while maintaining the machining quality.

### [Modification example]

### [Multi-path machining]

As in the above-described first embodiment, a so-called multi-path machining configuration in which a wiring layer removal groove C is machined by applying a plurality of machining feed operations may be adopted. In this case, in the second and subsequent machining feed operations, for example, the second laser beams L2A and L2B with the same intensity are emitted from the two second emission ports 102A and 102B to perform a hollowing process. Moreover, if necessary, the second laser beams L2A and L2B with different intensities may be emitted from the second emission ports 102A and 102B to perform the hollowing process.

### [Adjustment of intensity of second laser beam]

In the above-described embodiment, a configuration in which the amount of splitting of the second laser beam generated by the second laser beam generation unit 116 is adjusted to adjust the intensity of the second laser beams L2A and L2B emitted from the second emission ports 102A and 102B is adopted. Also, the 1/2 wavelength plate 118A and the polarizing beam splitter 118C are used as a means for adjusting the amount of splitting. The means for adjusting the amount of splitting of the second laser beam is not limited to this.

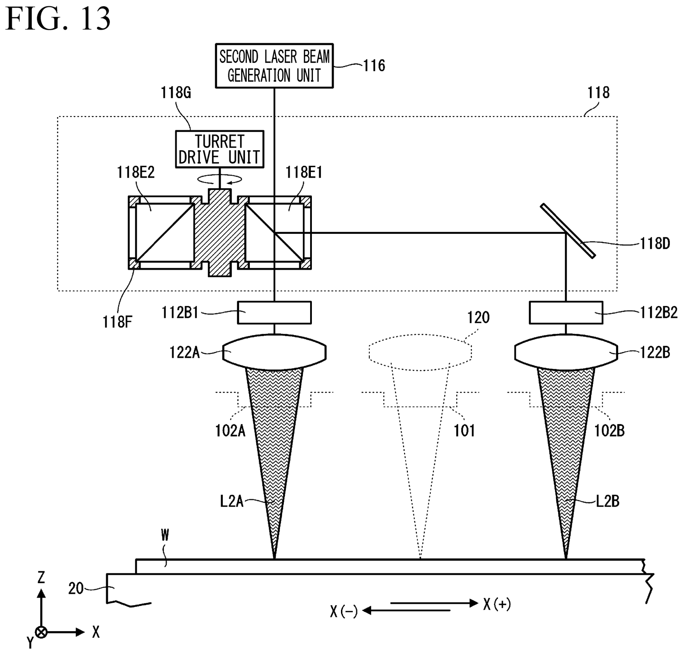

FIG. 13 shows another example of the means for adjusting the amount of splitting of the second laser beam.

FIG. 13 shows an example of adjusting amounts of splitting of the second laser beams L2A and L2B by switching the beam splitter to any one of a plurality of beam splitters with different splitting ratios to be used.

The optical path switching unit 118 in the example shown in FIG. 13 has a first beam splitter 118E1 and a second beam splitter 118E2 with different splitting ratios. The first beam splitter 118E1 and the second beam splitter 118E2 are held by a turret 118F. The turret 118F is driven by a turret drive unit 118G to rotate and switch the beam splitter to be used.

The first beam splitter 118E1 splits the incident light into transmitted light and reflected light at a first ratio. If the first beam splitter 118E1 is set on the optical path, the second laser beam generated by the second laser beam generation unit 116 is split into transmitted light and reflected light at the first ratio. As a result, the (2-1)^{th} laser beam L2A with the first intensity is emitted from the (2-1)^{th} emission port 102A and the (2-2)^{th} laser beam L2B with the second intensity is emitted from the (2-2)^{th} emission port 102B.

The second beam splitter 118E2 splits the incident light into transmitted light and reflected light at a second ratio. If the second beam splitter 118E2 is set on the optical path, the second laser beam generated by the second laser beam generation unit 116 is split into transmitted light and reflected light at the second ratio. As a result, the (2-1)^{th} laser beam L2A is emitted from the (2-1)^{th} emission port 102A at the second intensity, and the (2-2)^{th} laser beam L2B with the first intensity is emitted from the (2-2)^{th} emission port 102B.

In this way, a configuration in which the amount of splitting of the second laser beam is adjusted by switching the beam splitter to any one of a plurality of beam splitters with different splitting ratios to be used can be adopted.

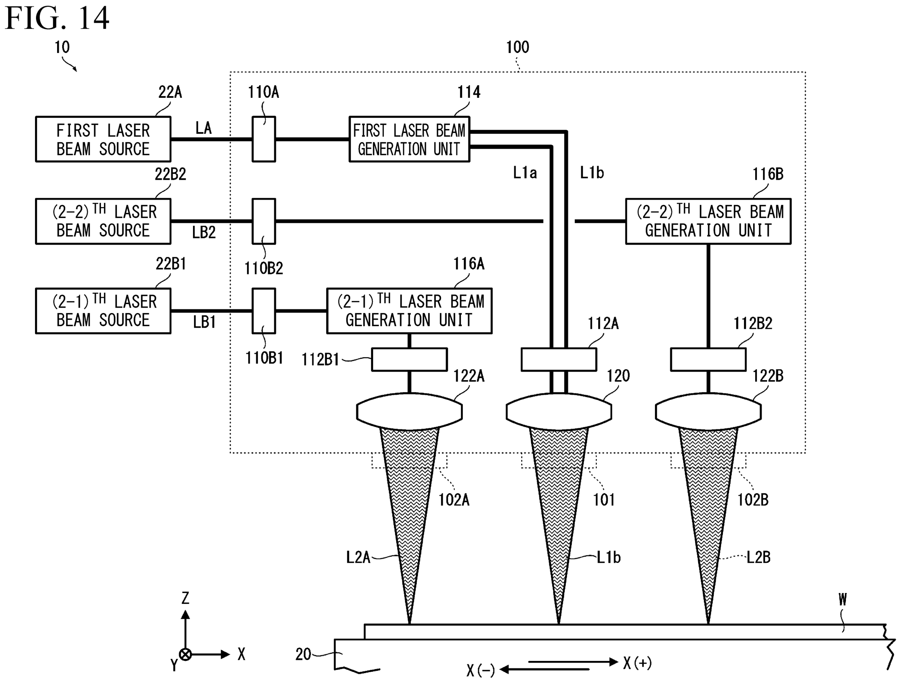

FIG. 14 is a diagram showing another example of a method of adjusting the intensity of the second laser beam.

FIG. 14 shows an example of a case where separate laser beam sources are provided and the intensities of the second laser beams L2A and L2B emitted from the second emission ports 102A and 102B are adjusted.

The laser machining device 10 of the example shown in FIG. 14 has a (2-1)^{th} laser beam source 22B1 and a (2-2)^{th} laser beam source 22B2 as light sources of the second laser beams L2A and L2B.

The (2-1)^{th} laser beam source 22B1 is a laser beam source of the (2-1)^{th} laser beam L2A emitted from the (2-1)^{th} emission port 102A. The laser beam LB1 emitted from the (2-1)^{th} laser beam source 22B1 is emitted from the (2-1)^{th} emission port 102A via the (2-1)^{th} safety shutter 110B1, the (2-1)^{th} high-speed shutter 112B1, the (2-1)^{th} laser beam generation unit 116A, and the (2-1)^{th} condenser lens 122A.

The emission of the (2-1)^{th} laser beam L2A from the (2-1)^{th} emission port 102A is controlled by controlling the opening and closing of the (2-1)^{th} safety shutter 110B1 and the (2-1)^{th} high-speed shutter 112B1. Moreover, the intensity of the (2-1)^{th} laser beam L2A emitted from the (2-1)^{th} emission port 102A is controlled by controlling the (2-1)^{th} laser beam generation unit 116A.

The (2-2)^{th} laser beam source 22B2 is a laser beam source of the (2-2)^{th} laser beam L2B emitted from the (2-2)^{th} emission port 102B. The laser beam LB2 emitted from the (2-2)^{th} laser beam source 22B2 is emitted from the (2-2)^{th} emission port 102B via the (2-2)^{th} safety shutter 110B2, the (2-2)^{th} high-speed shutter 112B2, the (2-2)^{th} laser beam generation unit 116B, and the (2-2)^{th} condenser lens 122B.

By controlling the opening and closing of the (2-2)^{th} safety shutter 110B2 and the (2-2)^{th} high-speed shutter 112B2, the emission of the (2-2)^{th} laser beam L2B from the (2-2)^{th} emission port 102B is controlled. Moreover, by controlling the (2-2)^{th} laser beam generation unit 116B, the intensity of the (2-2)^{th} laser beam L2B emitted from the (2-2)^{th} emission port 102B is controlled.

In this way, a configuration in which separate laser beam sources are provided and the intensities of the second laser beams L2A and L2B emitted from the second emission ports 102A and 102B are adjusted can be adopted. With this configuration, it is also possible to separately control the on/off state of the second laser beams L2A and L2B emitted from the second emission ports 102A and 102B.

### [Other embodiments]

### [Adjustment of spacing between edge cutting grooves]

Preferably, the spacing between the two edge cutting grooves C1a and C1b to be machined along the street St can be adjusted. The spacing between the edge cutting grooves C1a and C1b can be adjusted by changing the spacing in the Y direction, in other words, the spacing in a direction perpendicular to the machining feed direction, between the pair of first laser beams L1a and L1b emitted from the first condenser lens 120. The spacing in the Y direction between the pair of first laser beams L1a and L1b emitted from the first condenser lens 120 can be adjusted, for example, by rotating the emission positions around the optical axis of the first condenser lens 120. Moreover, the emission position can be rotated around the optical axis of the first condenser lens 120, for example, by rotating the diffractive optical element around the optical axis of the laser beam LA in the first laser beam generation unit 114.

The same applied to the hollowing process and the machining width can be adjusted by rotating the diffractive optical element around the optical axis in the second laser beam generation unit 116.

### [Hollowing process]

In the above-described embodiment, a single laser beam is emitted from a single condenser lens to perform the hollowing process. In other words, one of the second laser beams L2, L2A, and L2B is emitted from each of the second condenser lenses 122A and 122B. However, a configuration in which a plurality of laser beams are emitted from a single condenser lens to perform the hollowing process may be adopted. In this case, a plurality of second laser beams L2, L2A, and L2B that perform the hollowing process are aligned and output in the machining feed direction. In other words, a plurality of spots are formed in the machining feed direction. Moreover, in this case, a plurality of second laser beams L2 are generated in the second laser beam generation unit 116. As in the first laser beam generation unit 114, the plurality of second laser beams L2 can be generated using a diffractive optical element or the like. In this case, the outputs of the plurality of second laser beams L2 may be set to the same value or different values. For example, the output may be set to increase stepwise from the upstream side to the downstream side in the machining feed direction.

Although the hollowing process is performed with laser beams (second laser beams) having a rectangular spot shape in the above-described embodiment, the shape of the spot when the hollowing process is performed is not limited thereto. For example, the hollowing process may be performed with laser beams having a spot shape that is linear, circular, elliptical, or the like.

### [Configuration of relative movement between table and laser machining head]

Although the table 20 moves in the X and Y directions and rotates around the θ axis and the laser machining head 100 moves in the Z direction in the above-described embodiment, a relationship of movement between the table 20 and the laser machining head 100 is not limited thereto. It is only necessary to adopt a configuration in which relative movement is performed between the table 20 and the laser machining head 100. For example, the laser machining head 100 may be fixed, and the table 20 may move in three directions, i.e., the X, Y, and Z directions, and rotate around the θ axis. Alternatively, a configuration in which the table 20 moves in the X direction and rotates around the θ axis, and the laser machining head 100 moves in the Y and Z directions may be adopted. Moreover, a configuration in which the table 20 rotates around the θ axis at a fixed position, and the laser machining head 100 moves in three directions, i.e., the X, Y, and Z directions, may be adopted.

### [Laser machining unit]

Although a configuration in which the first machining unit configured to perform an edge cutting process and the two second machining units configured to perform a hollowing process are integrated (a configuration mounted on one laser machining head 100) has been described in the above-described embodiment, the first machining unit and the two second machining units may be configured separately. For example, a configuration in which the first machining unit and the second machining unit may be separated and moved separately in the Z direction or the like may be adopted.

### [Others]

Although the example in which the present invention is applied to a device for removing a wiring layer containing a low-k film from streets before dicing a semiconductor wafer using a low-k film as an interlayer insulating film has been described in the above-described embodiment, the application of the present invention is not limited thereto. The present invention can be applied to any device for machining grooves in a wafer by moving a table and a laser machining head relatively in a machining feed direction while radiating a laser beam from the laser machining head onto a wafer on the table.

### REFERENCE SIGNS LIST

10 Laser machining device
20 Table
22A First laser beam source
22B Second laser beam source
22B1 (2-1)^{th} laser beam source
22B2 (2-2)^{th} laser beam source
24 Microscope
26 Table drive unit
28 Head drive unit
30 Control device
30A Processor
30B Main storage device
30C Auxiliary storage device
30D Input device
30E Output device
100 Laser machining head
101 First emission port
102A Second emission port ((2-1)^{th} emission port)
102B Second emission port ((2-2)^{th} emission port)
110A First safety shutter
110B Second safety shutter
110B1 (2-1)^{th} safety shutter
110B2 (2-2)^{th} safety shutter
112A First high-speed shutter
112B1 Second high-speed shutter ((2-1)^{th} high-speed shutter)
112B2 Second high-speed shutter ((2-2)^{th} high-speed shutter)
114 First laser beam generation unit
116 Second laser beam generation unit
116A (2-1)^{th} laser beam generation unit
116B (2-2)^{th} laser beam generation unit
118 Optical path switching unit
118A 1/2 wavelength plate
118B Rotary drive unit
118C Polarizing beam splitter
118D Mirror
118E1 First beam splitter
118E2 Second beam splitter
118F Turret
118G Turret drive unit
120 First condenser lens
122A Second condenser lens ((2-1)^{th} condenser lens)
122B Second condenser lens ((2-2)^{th} condenser lens)
L1a Laser beam (first laser beam)
L1b Laser beam (first laser beam)
L2 Laser beam (second laser beam)
L2A Second laser beam ((2-1)^{th} laser beam)
L2B Second laser beam ((2-2)^{th} laser beam)
LA Laser beam from first laser beam source
LB Laser beam from second laser beam source
LB1 Laser beam from (2-1)^{th} laser beam source
LB2 Laser beam from (2-2)^{th} laser beam source
W Wafer
St Street
Dv Device
C Groove (wiring layer removal groove)
C1a Groove (edge cutting groove)
C1b Groove (edge cutting groove)

## Claims

1. A laser machining method of machining a second groove in a workpiece using a laser machining unit including a first machining unit capable of machining two first grooves in the workpiece by radiating a pair of laser beams to the workpiece to which a machining feed operation is relatively applied and two second machining units arranged on both sides of the first machining unit in a machining feed direction, the two second machining units being capable of machining an area between the two first grooves by radiating a laser beam between the two first grooves to be machined by the first machining unit, the laser machining method comprising:
machining the second groove formed by hollowing out an area between the two first grooves by applying a plurality of machining feed operations;
machining the area between the two first grooves with the second machining unit positioned on a downstream side of the first machining unit in a machining progress direction while machining the two first grooves in the workpiece with the first machining unit in a first machining feed operation; and
machining the area between the two first grooves using the two second machining units in second and subsequent machining feed operations.

2. The laser machining method according to claim 1, wherein an intensity of a laser beam emitted from the second machining unit changes at least between the first machining feed operation and the second and subsequent machining feed operations.

3. A laser machining method of machining a second groove in a workpiece using a laser machining unit including a first machining unit capable of machining two first grooves in the workpiece by radiating a pair of laser beams to the workpiece to which a machining feed operation is relatively applied and two second machining units arranged on both sides of the first machining unit in a machining feed direction, the two second machining units being capable of machining an area between the two first grooves by radiating a laser beam between the two first grooves to be machined by the first machining unit, the laser machining method comprising:
machining the second groove formed by hollowing out the area between the two first grooves in the workpiece by machining the area between the two first grooves machined by the first machining unit by radiating a laser beam with a first intensity to the workpiece from the second machining unit positioned on a downstream side of the first machining unit in a machining progress direction while machining the two first grooves in the workpiece with the first machining unit, and by machining in advance the area between the two first grooves to be machined by the first machining unit by radiating a laser beam with a second intensity lower than the first intensity from the second machining unit positioned on an upstream side of the first machining unit in a machining progress direction .

4. The laser machining method according to claim 3, comprising:
machining the second groove by applying a plurality of machining feed operations;
machining the area between the two first grooves machined by the first machining unit by radiating the laser beam with the first intensity to the workpiece from the second machining unit positioned on the downstream side of the first machining unit in the machining progress direction while machining the two first grooves in the workpiece with the first machining unit, and machining in advance the area between the two first grooves to be machined by the first machining unit by radiating the laser beam with the second intensity lower than the first intensity from the second machining unit positioned on the upstream side of the first machining unit in the machining progress direction, in a first machining feed operation; and
machining the area between the two first grooves by radiating laser beams with the first intensity from the two second machining units in second and subsequent machining feed operations.

5. The laser machining method according to claim 3 or 4,
wherein the workpiece is a semiconductor wafer using a low-k film in an interlayer insulating film, and
wherein the second intensity is set to an intensity lower than an intensity in which delamination occurs.

6. A laser machining device comprising:
a laser machining unit including a first machining unit capable of machining two first grooves in the workpiece by radiating a pair of laser beams to the workpiece to which a machining feed operation is relatively applied; and two second machining units arranged on both sides of the first machining unit in a machining feed direction, the two second machining units being capable of machining an area between the two first grooves by radiating a laser beam between the two first grooves to be machined by the first machining unit;
a table configured to hold the workpiece;
a machining feed unit configured to apply the machining feed operation by relatively moving the laser machining unit and the table; and
a control unit configured to control the machining by controlling the laser machining unit and the machining feed unit,
wherein the control unit controls the laser machining unit and the machining feed unit so that a second groove formed by hollowing out the area between the first grooves is machined in the workpiece according to a plurality of machining feed operations,
wherein the control unit controls the laser machining unit and the machining feed unit so that the area between the two first grooves is machined by the second machining unit positioned on a downstream side of the first machining unit in a machining progress direction while the first machining unit machines the two first grooves in the workpiece in a first machining feed operation, and
wherein the control unit controls the laser machining unit and the machining feed unit so that the area between the two first grooves is machined using the two second machining units in second and subsequent machining feed operations.

7. A laser machining device comprising:
a laser machining unit including a first machining unit capable of machining two first grooves by radiating a pair of laser beams to the workpiece to which a machining feed operation is relatively applied; and two second machining units arranged on both sides of the first machining unit in a machining feed direction, the two second machining units being capable of machining an area between the two first grooves by radiating a laser beam between the two first grooves to be machined by the first machining unit;
a table configured to hold the workpiece;
a machining feed unit configured to apply the machining feed operation by relatively moving the laser machining unit and the table; and
a control unit configured to control the machining by controlling the laser machining unit and the machining feed unit,
wherein the control unit controls the laser machining unit and the machining feed unit so that a second groove formed by hollowing out the area between the first grooves is machined in the workpiece according to at least one machining feed operation, and
wherein the control unit controls the laser machining unit and the machining feed unit so that the area between the two first grooves machined by the first machining unit is machined by radiating the laser beam with the first intensity to the workpiece from the second machining unit positioned on a downstream side of the first machining unit in a machining progress direction while the two first grooves are machined in the workpiece by the first machining unit and so that the area between the two first grooves to be machined by the first machining unit is machined in advance by radiating the laser beam with a second intensity lower than the first intensity from the second machining unit positioned on an upstream side of the first machining unit in the machining progress direction.

8. The laser machining device according to claim 7,
wherein the control unit controls the laser machining unit and the machining feed unit so that the second groove is machined in the workpiece by a plurality of machining feed operations,
wherein the control unit controls the laser machining unit and the machining feed unit so that the area between the two first grooves machined by the first machining unit is machined by radiating the laser beam with the first intensity to the workpiece from the second machining unit positioned on the downstream side of the first machining unit in the machining progress direction while the two first grooves are machined in the workpiece by the first machining unit and the area between the two first grooves to be machined by the first machining unit is machined in advance by radiating the laser beam with the second intensity lower than the first intensity from the second machining unit positioned on the upstream side of the first machining unit in the machining progress direction, in a first machining feed operation, and
wherein the control unit controls the laser machining unit and the machining feed unit so that the area between the two first grooves is machined by radiating laser beams with the first intensity from the two second machining units in second and subsequent machining feed operations.

9. The laser machining device according to claim 7 or 8,
wherein the workpiece is a semiconductor wafer using a low-k film in an interlayer insulating film, and
wherein the second intensity is set to an intensity lower than an intensity in which delamination occurs.
